Europäisches Patentamt

European Patent Office

Office européen des brevets

(11) Publication number: **0 171 949**
**B1**

## (12) EUROPEAN PATENT SPECIFICATION

(45) Date of publication of patent specification: **27.12.89**

(21) Application number: **85305217.3**

(22) Date of filing: **23.07.85**

(51) Int. Cl.⁴: **H 01 J 37/32, H 05 H 1/46**

(54) Microwave plasma etching apparatus.

(30) Priority: **23.07.84 JP 152363/84**

(43) Date of publication of application:
**19.02.86 Bulletin 86/08**

(45) Publication of the grant of the patent:
**27.12.89 Bulletin 89/52**

(84) Designated Contracting States:
**DE FR GB**

(56) References cited:
**DE-A-3 144 016**
**FR-A-2 402 301**

**F.F. CHEN: "Introduction to Plasma Physics",
1977, pages 27-31, Plenum Press, New York, US;
JOURNAL OF THE ELECTROCHEMICAL
SOCIETY, vol. 126, no. 6, June 1979, pages
1024-1028, Princeton, New York, US; K. SUZUKI
et al.: "The roles of ions and neutral active
species in microwave plasma etching"**

(73) Proprietor: **FUJITSU LIMITED
1015, Kamikodanaka Nakahara-ku
Kawasaki-shi Kanagawa 211 (JP)**

(72) Inventor: **Fujimura, Shuzo c/o Fujitsu Limited
Patent Department 1015 Kamikodanaka
Nakahara-ku Kawasaki-shi, 211 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

The present invention relates to microwave plasma processing apparatus for use, for example, for fabricating semiconductor integrated circuits (ICs).

In fabrication processes for forming fine patterns in IC devices, etching or ashing processes are assuming increasingly great importance. An etching process is a process for etching, for instance, a silicon substrate covered with a mask of a material such as silicon nitride, or a photoresist, or the like. From the beginning of the IC industry, "wet" etching utilizing chemicals has been employed. Recently, however, "dry" etching, such as plasma etching, is being employed. Dry etching has various advantages as compared with other etching methods, such as a capability for fine resolution, reduced under-cutting, a reduction of the number of the fabrication steps required, for example by elimination of wafer handling for rinsing and drying, inherent cleanness, and the like. In particular, plasma etching makes it possible to obtain an extremely fine pattern resolution, for example of sub-micron order, and to perform sequential etching and stripping operations on the same machine, which goes towards the attainment fully of automated IC fabrication.

A plasma is a highly ionized gas containing nearly equal numbers of positive and negative charged particles, namely electrons, and positive or negative ions, plus free radicals. The ions can be utilized for etching in a sputtering process, which is essentially a physical etching process, whilst the free radicals can be utilized for an essentially chemical etching process. The free radicals are chemically activated and electrically neutral atoms or molecules that can take part in chemical bonding actively with other materials with which they come into contact and are utilized in a plasma etching process as reactive species which chemically combine with materials to be etched. The gas (forming the plasma) and material (to be etched) are selected so that the material and the radicals thus combined form a volatile compound which can be removed from the etching system by an evacuating device. Consequently, etching utilizing free radicals is essentially a chemical etching.

Usually, a plasma etching apparatus comprises a plasma generating device, a reacting region (reaction chamber) and an exhausting device.

The basically required factors for plasma etching of an IC substrate are a high etching rate, anisotropic etching providing reduced side etching, and reduced damage to the substrate due to ion or electron bombardment, radiation with ultraviolet rays and the like.

Recently, in accordance with the demand for high packaging densities and high speed signal processing capabilities for ICs, etching patterns formed on IC substrates are required to be increasingly fine and precise. For example, wiring patterns having widths of so-called sub-micron dimensions such as 0.5 to 0.8 µm are coming into use. Such fine patterns are referred to as micro-patterns.

To achieve the accuracy necessary for precise micro-patterns, a plasma etching method having a highly anisotropic etching capability, provided by a high controllability of the directions of radicals and ions, is considered to be key technology. With an anisotropic etching method, functional particles, namely ions and free radicals, should be controlled so as to impinge almost perpendicularly on the surface of an IC substrate which is covered with a patterned lithographic mask of photoresist material, or silicon nitride, or the like. The etching process is then carried out perpendicularly onto an exposed surface of the substrate to provide that only little side etching or under-cutting of the patterned layer takes place, and that the etched pattern formed on the substrate has sufficient dimensional accuracy to allow a fine pattern of sub-micron order to be achieved with high reproducibility.

Advantages and disadvantages of previously proposed technologies will be surveyed briefly.

With an ion etching process, ions generated in a plasma are accelerated by an electric field, and impact the exposed surface of a substrate to be processed, to remove material of the substrate by virtue of their kinetic energy. The electric field is applied usually by an external electric source. The movement direction of the ions is controlled easily by the applied electric field, so that anisotropic etching can be afforded regardless of gas pressure. In addition, a high etching rate can be obtained with the use of a high accelerating potential and a high gas pressure. However, this is accompanied by a problem in that with ions of relatively high energy portions of a substrate under processing tend to be undesirably damaged by the ion bombardment. For example, photoresist material used as a mask for ion etching is carbonized by the ion bombardment. Fine wiring conductors made of doped polysilicon layer material may be damaged. Further, metal members of the etching apparatus which are bombarded by the ions are sputtered onto substrates under etching, and contaminate the substrates.

Such undesirable damage can be eliminated by the use of a low accelerating potential (energy). For this purpose, a substrate to be subject to etching is mounted in electrical isolation from the etching apparatus as a whole and is exposed to the plasma. The substrate is electrically floating and negatively charged against the plasma, resulting in formation of an ion sheath in front of the substrate under processing. This is caused by the difference between the velocity of electrons and that of ions in the plasma. The potentail drop across the ion sheath thus generated is referred to as a floating potential, being approximately 20 V. However, apparently, under these conditions the etching rate becomes substantially small.

On the other hand, plasma etching utilizing free radicals is entirely free from the disadvantage caused by sputtering. Unfortunately, the direction of the radicals is not controllable by an electric field because the radicals are electrically neutral. When a plasma etching is conducted in a relatively high gas pressure, such as 133.3 to 13.33 Pa (10 to $10^{-1}$ Torr), the mean free path of the gas molecules is as short as $5\times10^{-6}$ to $5\times10^{-5}$ m ($5\times10^{-2}$ to $5\times10^{-3}$ cm), and consequently multi-collisions between the molecules cause the molecules to move in random directions.

Accordingly, chemical etching (or after-glow etching) using a high gas pressure is not suitable for providing anisotropic etching as long as the free radicals play a role in the dry etching process. In order to overcome the defect described above and to afford a satisfactory anisotropic etching, a longer mean free path of the gas molecules, exceeding by far the dimensions of the etching apparatus, is necessary. This can be achieved with a reduced gas pressure, such as approximately 0.01333 Pa ($10^{-4}$ Torr). Radicals once ejected from a plasma in a given direction travel in straight lines until they impact the substrate, when the mean free path of gas molecules is sufficiently long, approximately 0.5 m (50 cm), in comparison with the dimensions of the etching apparatus. Therefore, radicals having desired initial directions (such that they will impinge almost perpendicularly on the surface to be etched) should be selected. However, a reduction of etching rate is inevitable, because the number of impacting radicals is reduced as gas pressure is reduced. In order to clarify the problems described above, some typical previously proposed etching apparatuses and technologies are described in the following.

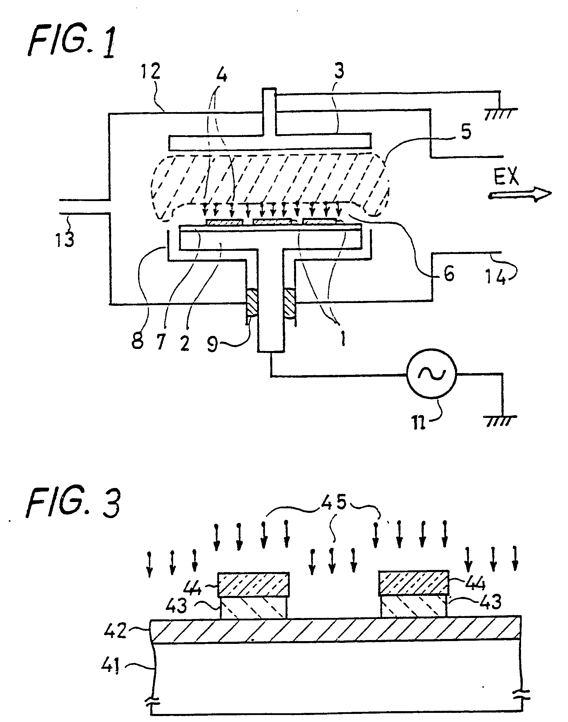

Fig. 1 is a schematic cross-sectional view of a reactive ion etching (RIE) apparatus. The Figure illustrates schematically the structure and the fundamental operating principle of the RIE apparatus.

In a vacuum tight vessel 12, a couple of electrodes 2 and 3 are arranged in parallel with one another. The vessel is evacuated by an exhausting pump system (not shown), through an exhausting tube 14, as indicated by an arrow EX. Gas is fed through a feeding tube 13. Workpieces (IC substrates) 1 to be etched are mounted on a quartz tray 7 arranged on the electrode 2 and radio frequency power of 13.75 GHz frequency is applied to the electrode 2 which is electrically isolated from ground and a plasma discharge 5 is generated between the two electrodes 2 and 3. Since the workpieces 1 are (electrically) isolated by an insulator 9, a cathode fall or ion sheath 6 is formed in front of the electrode 2. Ions 4 generated in the plasma 5 are accelerated by an electric field generated within the ion sheath 6 and impinge almost perpendicularly onto the workpieces 1 with an energy of approximately 100 eV, to etch the surfaces of the workpieces 1. The electrode 2 is shielded, for stabilizing the plasma 5, by a grounded shield 8. The ions are guided by the electric field inside the ion sheath 6 and impact the workpieces 1 almost perpendicularly with respect to their upper, exposed surfaces, and anisotropic etching is realised. The etching is substantially anisotropic, but damage due to ion sputtering is inevitable.

Another plasma etching method utilizing plasma ions is referred to as a reactive ion beam etching (RIBE). In this method ions are extracted from a plasma by a strong static electric field and impact workpieces (substrates) be etched. A plasma etching apparatus referred to as an "ion shower", proposed by Matsuo et al, disclosed in a Japanese laid open provisional 55-141729, is one apparatus using such a method. However, the accelerating energy of the ions is approximately 500 to 1000 eV, resulting in sputtering damage to workpieces.

In order to overcome such sputtering problems, various apparatuses have been proposed, such as a chemical dry etching (CDE) apparatus set forth by Horiike et al, disclosed in a U.S. Patent 4,192,706, 1980, whereby gas pressure is rather high, for example 133.3 to 13.33 Pa (10 to $10^{-1}$ Torr), and neutral radicals moving in random directions play a dominant role in the plasma etching process, resulting in isotropic etching which is not desirable for forming precise and fine micro-etching patterns.

An anisotropic plasma etching apparatus using a rather low gas pressure such as 0.1333 to 0.01333 Pa ($10^{-3}$ to $10^{-4}$ Torr) is reported in J. Electrochem. Soc., Vol. 128, No. 5, May 1981, "Low Energy Ion Beam Etching" by H. R. Kaufman et al. Substrates are mounted on an insulator and are isolated electrically, resulting in the creation of an ion sheath having a voltage drop of a floating potential of approximately 20 V thereacross as described above. Ions generated in plasma are accelerated by an electric field in the ion sheath. The results in little damage to micro-patterns formed on the substrates. The gas pressure is kept rather low, 0.0107 to 0.05332 Pa (0.8 to $4\times10^{-4}$) Torr for instance. The thickness of the ion sheath formed in front of the substrates is small in comparison with the mean free path of the ions, serving to allow the ions to move through the ion sheath without collision with other ions or molecules. Since the ions are guided along the electric flux inside the ion sheath, almost all the ions strike the surface of the workpiece in normal directions. Accordingly, etching of a precise micro-pattern can be achieved. The etching is considered to be performed by a coordination of radicals and ions, which is referred to as an "enhanced chemical etching" by the author. However, since the floating potential is utilized as an accelerating potential (energy) for the ions, the etching rate is substantially small and is not suitable for practical use.

Another etching apparatus utilizing low energy ions is reported by Suzuki et al. in J. Electrochem. Soc. Vol. 126, No. 6, June 1979 entitled "The Roles of Ions and Neutral Active Species in Microwave Plasma Etching". The apparatus is referred to as "magneto-microwave plasma etching apparatus" by the author, because the apparatus has a plasma discharging chamber immersed in a magnetic field. Microwave power at 2.45 GHz is fed through a wave guide to the plasma chamber, wherein a mirror magnetic field, generated in the direction of the microwave energy propagation using solenoids and a permanent magnet, is applied. A gas of low pressure, such as $CF_4$ gas at 0.006665 Pa ($5\times10^{-5}$ Torr), is fed into the plasma chamber and discharged by the microwave energy to generate a plasma. The magnetic field is utilised to drive electrons in the plasma to conduct Raman motion (cyclotron motion), increasing the possibility of collision with gas molecules to achieve a higher ionization efficiency. Thus, even with a low gas pressure, a sufficient number of ions can be obtained. A peak of the magnetic field intensity, namely, a mirror peak, is located at the opposite side of the plasma to a substrate to be etched. The substrate is electrically floating and exposed to the plasma. The accelerating energy of the ions is a floating potential of approximately 20 V as described in the preceding apparatus (Kaufman's apparatus). The etching is also performed in an anisotropic manner.

However, with such apparatus electrons generated in the plasma can travel straight into the vicinity of a substrate to be etched, wherein the electrons collide with neutral gas molecules (not radicals but not-ionized gas) to ionize them and newly create additive radicals. These newborn radicals have random movement directions, causing side etching, to reduce the anisotropic etching ability of the apparatus. In addition, when electrons from the plasma impinge onto a substrate to be etched, the kinetic energy of the electrons is converted into heat, elevating the temperature of the substrate. In some cases, such as when etching a substrate covered with a photoresist layer, the temperature elevation of the substrate causes a problem, softening the photoresist mask to reduce dimensional accuracy.

A plasma screening means, comprising four tungsten meshes extended in parallel to each other, is placed in front of the substrate, but by the use of such screening means, the etching rate becomes extremely small at a low gas pressure such as 0.01333 Pa ($10^{-4}$ Torr).

Still further, there is another example of low energy plasma etching apparatus developed by Akitani which was reported in the Third Dry Process Symposium, held on October 26—27, 1981 in Tokyo, under the title "Directional Dry Etching of Silicon by a Reactive Nozzle-Jet". With such apparatus, a free jet of radicals generated at a gas pressure of approximately 0.1 to 1.0 Torr is ejected from an aerodynamic nozzle system. A free-expansion process of the radicals from the nozzle to a vacuum space of approximately 0.01333 to 0.001333 Pa ($10^{-4}$ to $10^{-5}$ Torr) collimates the directions of motion of the radicals which initially have movements in random directions. The collimation of the directions of the radicals enables the radicals to impinge on the surface of a substrate with a low energy in a nearly normal direction. Although this results in the formation of a satisfactorily precise micropattern on a substrate, the etching rate is substantially small due to the extremely small nozzle diameter and is not applicable to a practical use.

Thus, despite considerable efforts, there has not been produced a substantially anisotropic microwave plasma etching apparatus which has a low energy ion etching system, a reasonable etching rate and which is suitable for practical use.

DE—A1—31 44 016 discloses high frequency plasma treatment apparatus, said to be usable for plasma etching. The apparatus has

a plasma generation chamber, wherein plasma is generated when the apparatus is in use, and

a reaction chamber, wherein a workpiece to be treated is held when the apparatus is in use.

The apparatus also has

means operable to deliver high frequency power to the plasma generation chamber, and means for introducing reaction gas to the plasma generation chamber.

The chambers are held under vacuum.

Coils are provided which generate a magnetic field providing a magnetic field intensity distribution having a cyclotron resonance point at which electron cyclotron resonance is caused in the plasma when the apparatus is in use.

Further coils are provided which generate magnetic fields in the reaction chamber for directing the plasma into perpendicular incidence onto the workpiece.

According to the present invention there is provided microwave plasma etching apparatus, comprising:

a plasma generation chamber, wherein plasma is generated when the apparatus is in use,

a reaction chamber, wherein a workpiece to be etched is held when the apparatus is in use,

means operable to deliver microwave power, at a predetermined frequency, into the plasma generation chamber,

means operable to introduce gas into the plasma generation chamber, and to maintain predetermined gas pressure in the chambers, and

magnetic field generation means operable to generate a magnetic field providing a magnetic field intensity distribution having a cyclotron resonance point, at which, in correspondence to the said predetermined frequency, cyclotron resonance of electrons is caused in the said plasma when the apparatus is in use, wherein

a connecting chamber is provided, connecting the plasma generation chamber and the reaction chamber in vacuum-tight fashion, and wherein

the magnetic field generation means provide the magnetic field also with a peak value point, affording a magnetic mirror such that electrons in the plasma are for the greater part prevented from intruding from the plasma generation chamber into the reaction chamber when the apparatus is in use.

An embodiment of the present invention can provide a microwave plasma etching apparatus having a substantially anisotropic etching ability and which substantially avoids undesired damage to a workpiece (substrate) under etching processing.

An embodiment of the present invention can provide microwave plasma processing apparatus for etching or ashing of a workpiece (an IC substrate), having an improved anisotropic etching ability and processing rate.

An embodiment of the present invention can provide an anisotropic microwave plasma etching apparatus having means providing for operation at a relatively low gas pressure, and having means preventing electrons generated in plasma from intruding into the space in the vicinity of a workpiece to be etched, maintaining a high anisotropic etching ability and reducing temperature rise of the workpiece due to electron bombardment.

Firstly, in order to realise a substantially anisotropic etching for forming a micro-pattern of submicron order on a workpiece (an IC substrate for example) apparatus in accordance with an embodiment of the present invention is provided with means for attaining a gas pressure, as low as 0.1333 to 0.01333 Pa ($10^{-3}$ to $10^{-4}$ Torr) for example, affording a long mean free path for gas molecules which exceeds the dimensions of the apparatus.

Secondly, in order to protect the formed micro-pattern from damage due to ion bombardments, apparatus is such that the accelerating energy of ions generated in the plasma is selected to be as low as possible. Practically, a floating potential of approximately 20 V, created by an electrically isolated workpiece (substrate) which is exposed in a plasma is utilized.

Thirdly, in order to increase generating efficiency of ions and radicals in the plasma, the apparatus has means for generating a magnetic mirror to provide electrons in the plasma with cyclotron motion to increase the probability of collison with gas molecules in the plasma.

There are two further features provided in the apparatus, for achiving a satisfactory anisotropic etching.

One problem, which must be avoided if satisfactory anisotropic etching is to be achieved, is caused by radicals generated in the plasma, flying with their heat energy and having random initial directions of movement.

In apparatus embodying the invention, radicals having undesirable directions of movement are effectively shut out. That is, radicals which would otherwise have oblique impinging directions onto a workpiece, exceeding a predetermined angle, are eliminated.

Another problem is caused by electrons generated in the plasma. If electrons in the plasma move into a space in the vicinity of the workpiece, they can collide with neutral gas molecules to create new ions and new radicals which have uncontrollable random movement directions. Therefore, the electrons should be shut out from the vicinity of the workpiece. However, ions and radicals must move toward the workpiece.

In the embodiment of the present invention a magnetic mirror is used for such shutting out.

In the embodiment of the present invention, means for shutting out radicals having undesired directions of movement, and electrons, comprise a connecting chamber connecting the plasma chamber to the reaction chamber and acting as a geometric barrier, and magnetic mirror generating means such as a solenoid or a permanent magnet arranged around the connecting chamber, acting as magnetic shutting out means.

A proportion of radicals, ions and electrons generated in plasma travel through the connecting chamber to the reaction chamber. The inside shape of the connecting chamber is designed in a similar manner to an optical aperture so that the eventual angle of impingement of the travelling particles onto a workpiece, with respect to the normal to the surface of the workpiece, is limited by the inner wall of the connecting chamber (to less than a predetermined angle). As the result, the radicals from the plasma which are allowed to impinge on the workpiece can etch the workpiece almost perpendicularly resulting in an anisotropic etching of the workpiece.

The magnetic mirror is created amid the connecting chamber, by a solenoid for example, to reflect the electrons at a peak point of the magnetic field of the solenoid, which peak point is between the reaction chamber and the plasma chamber, in the connecting chamber. Thus, electrons are confined in the plasma and shut out from the vicinity of the workpiece.

The magnetic mirror, although *per se* a well-known apparatus, plays two roles in an embodiment of the present invention. One is for enhancing the plasma density utilizing a cyclotron resonance phenomena, and the other is for shutting out electrons from the vicinity of the workpiece.

In another embodiment of the invention, a magnetic field is generated by two solenoids spaced apart from each other, providing a magnetic field profile with two peak points Pm, one of which is generated as described above (in the connecting chamber) and the other which is located approximately at an end of the plasma chamber opposite to the connecting chamber. As the result, a concave profile of magnetic field intensity distribution along an axis from plasma chamber to reaction chamber is formed, preventing generated particles in the plasma, ions and electrons, from being consumed by contact with the inner wall of the plasma chamber, leading to an increase in plasma generating efficiency. The level of the magnetic field intensity at the bottom of the concave profile is selected to be slightly lower than that of a cyclotron resonance point.

Reference is made, by way of example, to the accompanying drawings, in which:—

Fig. 1 is a schematic cross-sectional view of a previously proposed microwave reactive ion etching apparatus, given for assistance in explaining principles of operation of microwave plasma etching,

Fig. 2(a) is a schematic cross-sectional view of an apparatus embodying the present invention,

Fig. 2(b) is a graphical diagram illustrating magnetic field intensity distribution along an X axis shown in Fig. 2(a),

Fig. 3 is a partial cross-sectional view, to an enlarged scale, of an IC substrate subject to an etching process, illustrating anisotropic etching,

Fig. 4(a) is a schematic cross-sectional view of another apparatus embodying the present invention, and

Fig. 4(b) is a graphical diagram illustrating magnetic field intensity distribution along an X axis shown in Fig. 4(a).

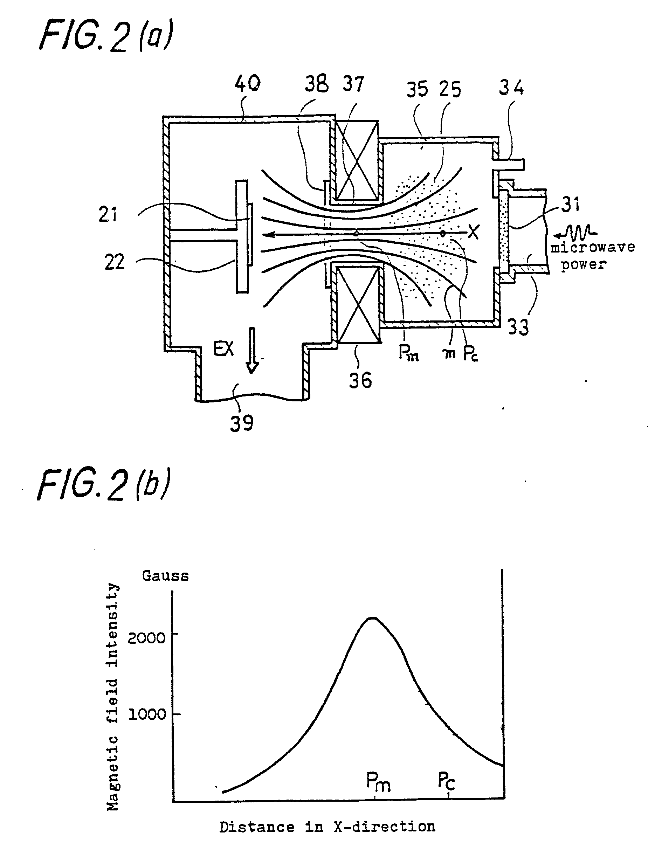

Fig. 2(a) is a cross-sectional view of an embodiment of the present invention, illustrating schematically the structure of the apparatus for assistance in explaining etching operation in the apparatus.

Microwave energy is supplied from a microwave power source (not shown) through microwave guiding means, such as a wave guide 33, into a plasma chamber 35. The wave guide 33 and the plasma chamber 35 are separated from each other by a vacuum tight window 31 of a low loss inductive material such as a high alumina, which allows passage of microwave energy and simultaneously forms a part of (defines a boundary of) the plasma chamber 35. Adjacent to the plasma chamber 35, a magnetic mirror generating portion is positioned, comprising a connecting chamber 37 and a solenoid 36 which surrounds the outside of the connecting chamber 37. For example, the solenoid 36 has a total of 220 turns, an inner diameter of 0.1 m (100 mm) and an axial length of 0.083 m (83 mm). The connecting chamber 37 connects the plasma chamber 35, including the alumina window 31, with a reaction chamber 40 vacuum tightly as shown in Fig. 2(a), to form a vacuum vessel, which is evacuated through an exhausting tube 39, by an exhausting system (not shown).

In the connecting chamber 37, a magnetic mirror is created by the solenoid 36. The magnetic field intensity distribution of the magnetic mirror has a convex profile in a direction X represented by an arrow in Fig. 2(a). The curve of the profile starts, as shown in Fig. 2(b), from a low magnetic field intensity and gradually goes up passing through a zone having a magnetic intensity of 0,0875 T (875 Gauss), which is necessary to cause cyclotron resonance for the particles (electrons) excited by microwave energy at 2.45 GHz. A point corresponding to such intensity is referred to as a cyclotron resonance point Pc. Then the curve goes up to reach a peak point Pm having a magnetic field intensity of approximately 0.15 to 0.25 T (1.5 to 2.5 KGauss), and then gradually falls down. The magnetic fluxes (signified by m) extend through the plasma chamber 35, the connecting chamber 37 and the reaction chamber 40 as shown in Fig. 2(a). The cyclotron resonance point Pc is located almost in the middle portion of the plasma chamber 35 and the peak point Pm is located amid the connecting chamber 37.

A shielding filter 38, of approximately 5 mm thickness and having therein a number of holes of 2 to 3 mm diameter, is disposed between the connecting chamber 37 and the reaction chamber 40, for allowing the passage of radicals and ions generated in the plasma and for preventing the leakage of microwave power into the reaction chamber 40, as is described later.

In the reaction chamber 40, a workpiece, an IC substrate 21, for example, is placed on a mounting table 22 positioned at a distance from the peak point Pm which is smaller than the associated mean free path of the radicals. The plasma chamber 35, the connecting chamber 37, the shielding filter 38, reaction chamber 40 and the table 22 are made of metal such as aluminium which is resistant to etching by the radicals.

An anisotropic plasma etching process for etching a polysilicon substrate 21 mounted on the table 22, utilising the apparatus of Fig. 2(a) will be described.

The chambers are evacuated in advance to below a predetermined vacuum degree such as 0.001333 Pa ($10^{-5}$ Torr). Subsequently, fluorine gas ($F_2$) is introduced through a gas inlet tube 34 connected to the plasma chamber 35, maintaining a predetermined gas pressure such as approximately 0.01333 Pa ($10^{-4}$ Torr). Microwave energy at 2.45 GHz, for instance, is propagated through the wave guide 33 into the plasma chamber 35, and simultaneously a convex magnetic field, namely a magnetic mirror as described above, is formed by energizing the solenoid 36. Thus, the fluorine gas is discharged to form a plasma. Being accelerated and multiplied by a cyclotron resonance phenomena generated by the combined application of the microwave energy at 2.45 GHz and exposure in the magnetic field zone of 0.0875 T (875 Gauss) at the cyclotron resonance point Pc of the magnetic field, a great number of electrons, radicals and ions are generated in the plasma to form a substantially dense cloud of electrons, in spite of a relatively low spatial density of the gas. The electrons, radicals, and ions which have some velocity component in the axial direction X, begin to move toward the substrate 21. Since the mean free path of these particles is maintained sufficiently long, for example 50 cm, and exceeds the dimensions of the plasma chamber 35, connecting chamber 37 and reaction chamber 40, the probability of the mutual collision of the particles and the walls of the chambers is significantly small. As the result, the electrons, radicals and ions are considered to maintain their initial modes of movement in the plasma. Accordingly, the electrons maintain cyclotron movement and the radicals and ions move in almost straight lines.

The electrons, performing cyclotron motion, move towards the reaction chamber losing their axial velocity component towards the reaction chamber due to the gradually increasing magnetic flux density (from the point Pc) along the axis X of the magnetic field, until the axial velocity component of the electrons reaches zero and then achieves a negative value near the peak point Pm of the magnetic field. Consequently, most of the electrons are reflected back toward the plasma chamber 35.

The reflecting efficiency of a magnetic mirror depends on a mirror ratio which is defined by the ratio of the maximum magnetic field intensity to the minimum field intensity involved in the mirror. In the present case, the minimum magnetic field intensity is defined to be 0.0875 T (875 Gauss), since the magnetic mirror is effecting the electrons generated in the plasma. A mirror ratio between 2 and 3, namely a maximum magnetic field intensity of 0.15 to 0.25 T (1.5 to 2.5 KGauss) at Pm, is found to provide the highest reflecting efficiency of approximately 90%. Therefore, in general, the mirror ratio of the magnetic mirror should be selected in the range 2 to 3.

By means of the magnetic mirror described above, most of the electrons generated in the plasma 25 are prevented from being injected into the reaction chamber (F. F. Chen, "Introduction to Plasma Physics", 1977, pages 27 to 31, Plenum Press, New York, USA). Neutral radicals and ions in the plasma 25, which do not suffer cyclotron motion, pass through the magnetic mirror and the shielding filter 38, impinge onto the substrate 21, reacting with the material of the substrate 21 to form volatile products which are evacuated from the vacuum system. Thus, plasma etching is performed.

Since almost none of the electrons generated in the plasma 25 reach the reaction chamber, radicals having random movement directions are rarely generated newly in the reaction chamber 40. This ensures significantly improved anisotropic plasma etching.

In conclusion, the magnetic mirror having the peak point Pm amid the connecting chamber 37 and a cyclotron resonance point Pc amid the plasma chamber, plays a double role, namely, a role of generating cyclotron resonance of electrons for enhancing plasma density and a role as a magnetic reflector for preventing the electrons in the plasma from invading the reacting chamber.

The connecting chamber 37 not only provides a space for a magnetic mirror, but also plays a role as limiter of a kind or an aperture for the passage of neutral radicals therethrough. The aperture-like function is provided by the dimensions and the shape of the inner wall of the connecting chamber 37. The higher the ratio of the axial length of the connecting chamber 37 to the inner width or depth of the connecting chamber 37 the greater is the collimating effect on the radicals; that is, only radicals moving in directions near normal to the surface of the substrate 21 are allowed to impinge on the surface of the substrate.

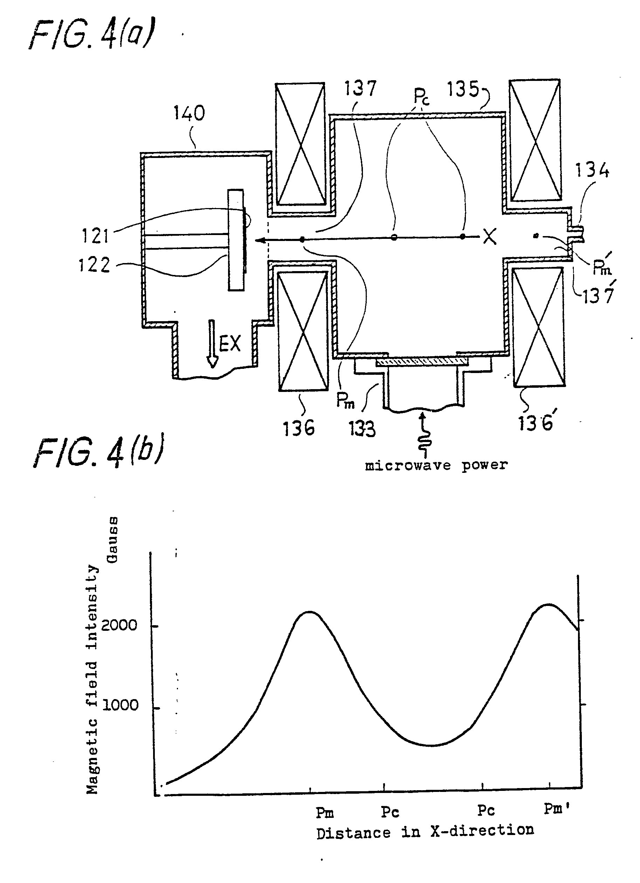

Employing a microwave plasma etching apparatus as shown in Fig. 2(a), a substantially anisotropic plasma etching process can be performed as described below with reference to the schematic cross-sectional view of Fig. 3. A workpiece 41 is a silicon substrate, for example, covered with a double layer comprising an insulator layer 42, such as a silicon dioxide (SiO₂) layer, and polysilicon layer 43, as shown in Fig. 3. The substrate is masked by a photoresist mask 44 and mounted on the table of the plasma etching apparatus. Ions and radicals 45 impinge onto the surface of the substrate 41 and plasma etching is performed. The particles 45 of radicals and ions have substantially small energy; that is they have inherent thermal energy sufficient for giving them their initial velocity. Electrons generated in the plasma do not impinge the substrate. As the result, the photoresist mask is free from damage such as carbonisation and softening of the photoresist mask, which often occurs with previous plasma etching apparatuses. Particularly, the underlying silicon dioxide layer 43 is not damaged by ion bombardment because the energy of the bombardment is low. The radicals impinge on the substrate 41 in almost normal directions with respect to the surface of the substrate, as described above. Thus side walls of the etched pattern are almost perpendicular to the surface of the substrate. Such a significantly anisotropic plasma etching enables the formation of a micropattern of sub-micron order such as 0.5 μm.

The shielding filter 38 will now be described with reference to Fig. 2(a). A part of the microwave power which is not absorbed by the plasma might, in the absence of filter 38, propagate into the reaction chamber. Such leakage of microwave power is prevented by the shielding filter 38. If it were not, a new plasma might be generated in the reaction chamber 40 and a cyclotron resonance might occur due to the extension of the magnetic field into the chamber 40, generating new radicals having uncontrollable random directions and adversely affecting the anisotropy of the plasma etching.

The shielding filter 38 is located behind the peak point Pm as seen from the plasma 25 as shown in Fig. 2(a) and is not exposed in the plasma. This is because electrons are reflected and shut out by the peak point Pm of the magnetic mirror before accessing the space adjacent to the shielding filter 38 and no ion sheath is formed thereon.

Fig. 4(a) is a schematic cross-sectional view of a further embodiment of the present invention, wherein the plasma generating efficiency in the plasma chamber is further increased by an additional magnetic peak point Pm' of the magnetic mirror, as shown in Fig. 4(b). The additional peak point Pm' prevents charged particles, electrons and ions, in the plasma being consumed by contact with the inner wall of the plasma chamber.

In Fig. 4(a), items similar to items shown in Fig. 2(a) are indicated by the reference number used in Fig. 2(a) with the addition of one hundred. E.g. reaction chamber "40" in Fig. 2(a) corresponds to reaction chamber "140" in Fig. 4(a).

The apparatus in Fig. 4(a) differs from that of Fig. 2(a) as will be seen by a comparison of those Figures. In particular the arrangements for injecting microwave power and gas into the plasma chamber differ, and the apparatus of Fig. 4(a) includes an additional solenoid 136'.

Basically, however, the embodiment of Fig. 4(a) has a similar structure to that of the embodiment of Fig. 2(a), except that the profile of the magnetic field intensity distribution along the X-axis has two peak points Pm and Pm'. The peak point Pm located amid the connecting chamber 137 plays the same role as in embodiment of Fig. 2(a). The additional peak point Pm', which is created by an added solenoid 136' arranged outside a sub-plasma chamber 135', is located at the side of the plasma chamber 135 opposite to the connecting chamber 137. As a result, the magnetic field intensity distribution curve along the X-axis, shown by an arrow X in Fig. 4(a), has two peak points as shown in Fig. 4(b), wherein the ordinate is magnetic field intensity and abscissa shows position along the X-axis. As can be seen from the graph in Fig. 4(b), the plasma chamber 135 is immersed in a magnetic field having a concave distribution profile along the X-axis, resulting in a confinement of electrons to prevent them touching the inner wall of the plasma chamber 135. Consequently, consumption of electrons in the plasma is substantially reduced, leading to an increase in the plasma generating efficiency. An etching operation using the plasma etching apparatus of Fig. 4(a) is similar to that using the etching apparatus of Fig. 2(a), as shown in Fig. 3 for example.

An embodiment of the present invention provides a microwave plasma etching apparatus comprising:

a microwave power source for generating a microwave having a predetermined frequency;

a microwave transmitting means for transmitting said microwave from said power source;

a plasma generating chamber for generating a plasma therein;

a reaction chamber for processing a workpiece to be etched accommodated therein at a predetermined position;

a connecting chamber connecting said plasma generating chamber and said reaction chamber to form a vacuum-tight vessel; and

a magnetic mirror generating means for generating a magnetic field, having a cyclotron resonance point at which the magnetic field thereof causes a cyclotron resonance to electrons in said plasma corresponding to said frequency of said microwave, and a peak point at which said magnetic field intensity has the maximum value,

gas having a predetermined gas pressure being introduced into said vacuum-tight vessel, said microwave being introduced into said plasma generating chamber through said microwave transmitting means, said magnetic mirror generating means generating a magnetic field extending in said plasma generating chamber and said connecting chamber, thus generating a plasma comprising a great number of electrons, free radicals and ions therein, said generating plasma being enhanced at said cyclotron resonance point of said magnetic mirror, a greater part of said electrons being reflected by said magnetic mirror preventing said electrons intruding into said reaction chamber and said radicals and said ions being allowed to pass said magnetic mirror to impinge on said workpiece to perform a substantially anisotropic plasma etching thereof.

In such apparatus the inner wall of said connecting chamber may serve to limit said electrons generated in said plasma so that a part of said electrons which has a larger angle made to the normal to the surface of said workpiece.

In such apparatus an additional peak point of the magnetic field intensity may be included in the magnetic field of said magnetic mirror, said additional peak point of the magnetic field intensity being located at the opposite side of the plasma chamber to said connecting chamber, confining most of the electrons contained in said plasma with coordination of said peak point.

**Claims**

1. Microwave plasma etching apparatus, comprising:

a plasma generation chamber (35; 135), wherein plasma is generated when the apparatus is in use,

a reaction chamber (40; 140), wherein a workpiece (21; 121) to be etched is held when the apparatus is in use,

means (33, 31; 133) operable to deliver microwave power, at a predetermined frequency, into the plasma generation chamber,

means (34; 134) operable to introduce gas into the plasma generation chamber, and to maintain predetermined gas pressure in the chambers, and

magnetic field generation means (36; 136, 136') operable to generate a magnetic field providing a magnetic field intensity distribution having a cyclotron resonance point (Pc), at which, in correspondence to the said predetermined frequency, cyclotron resonance of electrons is caused in the said plasma when the apparatus is in use, wherein

a connecting chamber (37; 137) is provided, connecting the plasma generation chamber and the reaction chamber in vacuum-tight fashion, and wherein

the magnetic field generation means (36; 136, 136') provide the magnetic field also with a peak value point (Pm), affording a magnetic mirror such that electrons in the plasma are for the greater part prevented from intruding from the plasma generation chamber into the reaction chamber when the apparatus is in use.

2. Apparatus as claimed in claim 1, wherein the predetermined gas pressure is less than 0.1333 Pa ($10^{-3}$ Torr), for example approximately 0.01333 Pa ($10^{-4}$ Torr).

3. Apparatus as claimed in claim 1 or 2, wherein the connecting chamber (37; 137), and the reaction (40; 140) and plasma generation (35, 135) chambers, are so configured as to provide a collimation effect, whereby only those ions and radicals, generated in the plasma when the apparatus is in use, which travel in a selected range of directions such that they will impinge substantially perpendicularly upon a surface of the workpiece (21; 121) properly held in the reaction chamber when the apparatus is in use, are allowed to impinge upon that surface.

4. Apparatus as claimed in claim 1, 2 or 3, wherein the said peak value point (Pm) is located between the said cyclotron resonance point (Pc) and the workpiece (21; 121) properly held in the reaction chamber (40; 140).

5. Apparatus as claimed in claim 4, wherein the magnetic field intensity distribution has a further peak value point (Pm') located at that side of the plasma generation chamber (35; 135) away from the connecting chamber (37; 137) and the reaction chamber (40; 140).

6. Apparatus as claimed in any preceding claim, wherein the predetermined frequency is approximately 2.45 GHz, and magnetic field intensities at the cyclotron resonance point (Pc) and the peak value point (Pm) of claim 1 are 0.0875 T (875 Gauss), and 0.15 to 0.25 T (1.5 KGauss to 2.5 KGauss) respectively.

7. Apparatus as claimed in any preceding claim, wherein the mirror ratio of the magnetic mirror is in the range 2 to 3.

8. Apparatus as claimed in any preceding claim, wherein the magnetic field generation means (36; 136, 136') comprise at least one solenoid (36; 136).

9. Apparatus as claimed in any preceding claim, wherein the chambers (37, 35, 40; 137, 135, 140) are formed of aluminium.

10. Apparatus as claimed in any preceding claim, further comprising a shielding filter (38), positioned between the peak value point (Pm) of claim 1 and the reaction chamber (40; 140), serving to prevent leakage of microwave power into the reaction chamber, the filter being provided with holes to allow passage of radicals and ions.

**Patentansprüche**

1. Mikrowellenplasmaätzvorrichtung mit:

einer Plasmaerzeugungskammer (35; 135), in der Plasma erzeugt wird, wenn die Vorrichtung in Betrieb ist;

einer Reaktionskammer (40; 140), in welcher ein Werkstück (21; 121), das geätzt werden soll, gehalten wird, wenn die Vorrichtung in Betrieb ist;

Einrichtungen (33, 31; 133), die betreibbar sind, um in die Plasmaerzeugungskammer Mikrowellenenergie bei einer vorbestimmten Frequenz zu liefern,

Einrichtungen (34; 134), die betreibbar sind, um in die Plasmaerzeugungskammer Gas einzuführen und einen vorbestimmten Gasdruck in den Kammern aufrechtzuerhalten, und

Magnetfelderzeugungseinrichtungen (36; 136, 136'), die betreibbar sind, um ein Magnetfeld zu erzeugen, das eine Magnetfeld-Intensitätsverteilung aufweist, welche einen Zyklotron-Resonanzpunkt (Pc) hat, bei dem, in Übereinstimmung mit der genannten vorbestimmten Frequenz, Zyklotron-Resonanz der Elektronen in dem genannten Plasma bewirkt wird, wenn die Vorrichtung in Betrieb ist, bei der

eine Verbindungskammer (37; 137) vorgesehen ist, welche die Plasmaerzeugungskammer und die Reaktionskammer in vakuumdichter Weise verbindet, und bei der

die Magnetfelderzeugungseinrichtung (36; 136, 136') das Magnetfeld auch mit einem Spitzenwertpunkt (Pm) erzeugen, welcher einen magnetischen Spiegel bildet, so daß der größter Teil der Elektronen in dem Plasma daran gehindert sind, aus der Plasmaerzeugungskammer in die Reaktionskammer einzudringen, wenn die Vorrichtung in Betrieb ist.

2. Vorrichtung nach Anspruch 1, bei der der vorbestimmte Gasdruck geringer als 0,1333 Pa ($10^{-3}$ Torr), zum Beispiel etwa 0,01333 Pa ($10^{-4}$ Torr) ist.

3. Vorrichtung nach Anspruch 1 oder 2, bei der die Verbindungskammer (37; 137) und die Reaktions—(40; 140)—und Plasmaerzeugungs—(35, 135)—kammern so konfiguriert sind, daß sie einen Kollimationseffekt liefern, wodurch nur jene Ionen und Radikale, die in dem Plasma erzeugt werden, wenn die Vorrichtung in Betrieb ist, die in einem ausgewählten Bereich von Richtungen wandern, so daß sie im wesentlichen senkrecht auf eine Oberfläche des Werkstückes (21; 121) auftreffen, welches ordentlich in der Reaktionskammer gehalten wird, wenn die Vorrichtung in Betrieb ist, auf jene Oberfläche auftreffen können.

4. Vorrichtung nach Anspruch 1, 2 oder 3, bei der der genannte Spitzenwertpunkt (Pm) zwischen dem genannten Zyklotron-Resonanzpunkt (Pc) und dem Werkstück (21; 121), das ordentlich in der Reaktionskammer (40; 140) gehalten wird, angeordnet ist.

5. Vorrichtung nach Anspruch 4, bei dem die Magnetfeldintensitätsverteilung einen weiteren Spitzenwertpunkt (Pm') hat, der an jener Seite der Plasmaerzeugungskammer (35; 135) angeordnet ist, die von der Verbindungskammer (37; 137) und der Reaktionskammer (40; 140) entfernt ist.

6. Vorrichtung nach einem der vorhergehenden Ansprüche, bei der die vorbestimmte Frequenz etwa 2,45 GHz beträgt, und die Magnetfeldintensitäten bei dem Zyklotron-Resonanzpunkt (Pc) und dem Spitzenwertpunkt (Pm) von Anspruch 1 0,0875 T (875 Gauss), beziehungsweise 0,15 bis 0,25 T (1,5 KGauss bis 2,5 KGauss) sind.

7. Vorrichtung nach einem der vorhergehenden Ansprüche, bei der das Spiegelverhältnis des magnetischen Spiegels im Bereich 2 bis 3 ist.

8. Vorrichtung nach einem der vorhergehenden Ansprüche, bei der die Magnetfelderzeugungseinrichtungen (36; 136, 136') wenigstens ein Solenoid (36; 136) umfassen.

9. Vorrichtung nach einem der vorhergehenden Ansprüche, bei der die Kammern (37, 35, 40; 137, 135, 140) aus Aluminium gebildet sind.

10. Vorrichtung nach einem der vorhergehenden Ansprüche, ferner mit einem Abschirmfilter (38), das zwischen dem Spitzenwertpunkt (Pm) von Anspruch 1 und der Reaktionskammer (40; 140) angeordnet ist und dazu dient, ein Auslekken von Mikrowellenenergie in die Reaktionskammer zu verhindern, wobei das Filter mit Löchern versehen ist, um den Durchgang von Radikalen und Ionen zu erlauben.

**Revendications**

1. Appareil d'attaque par plasma à ondes hyperfréquences, comprenant:

une chambre de génération de plasma (35; 135), dans laquelle un plasma est généré quand l'appareil est en fonctionnement;

une chambre de réaction (40; 140), dans laquelle une pièce à travailler (21; 121) à attaquer est maintenue quand l'appareil est en fonctionnement;

un moyen (33, 31; 133) pouvant être mis en fonctionnement pour fournir une puissance en hyperfréquence, à une fréquence prédéterminée, dans la chambre de génération de plasma,

un moyen (34; 134) pouvant être mis en fonctionnement pour introduire un gaz dans la chambre de génération de plasma, et pour maintenir une pression de gaz prédéterminée dans les chambres, et

un moyen de génération de champ magnétique (36; 136, 136') pouvant être mis en fonctionnement pour générer un champ magnétique fournissant une répartition d'intensité de champ magnétique comportant un point de résonance cyclotron (Pc) où, en correspondance avec la fréquence prédéterminée, une résonance cyclotron des électrons est produite dans le plasma quand l'appareil est en fonctionnement, dans lequel

une chambre de liaison (37; 137) est prévue, reliant la chambre de génération de plasma et la chambre de réaction d'une manière hermétique, et dans lequel

le moyen de génération de champ magnétique (36; 136, 136') fournit le champ magnétique également avec un point de valeur de crête (Pm), en procurant un miroir magnétique tel que les électrons dans le plasma sont en grande partie empêchés de s'introduire de la chambre de génération de plasma dans la chambre de réaction quand l'appareil est en fonctionnement.

2. Appareil selon la revendication 1, dans lequel la pression de gaz prédéterminée est inférieure à 0,1333 Pa ($10^{-3}$ Torr), par exemple égale approximativement à 0,01333 Pa ($10^{-4}$ Torr).

3. Appareil selon l'une quelconque des revendications 1 et 2, dans lequel la chambre de liaison (37; 137), et la chambre de réaction (40; 140) et les chambres de génération de plasma (35, 135) ont une structure telle qu'elles fournissent un effet de mise en parallèle par lequel uniquement les ions et les radicaux, générés dans le plasma quand l'appareil est en fonctionnement, qui se déplacent dans une plage de directions, sélectionnée telle qu'ils frappent essentiellement perpendiculairement la surface de la pièce à travailler (21; 121) convenablement maintenue dans la chambre de réaction quand l'appareil est en fonctionnement, sont autorisés à frapper cette surface.

4. Appareil selon l'une quelconque des revendications 1 à 3, dans lequel le point de valeur de crête (Pm) est situé entre le point de résonance cyclotron (Pc) et la pièce à travailler (21; 121) convenablement maintenue dans la chambre de réaction (40; 140).

5. Appareil selon la revendication 4, dans lequel la répartition d'intensité de champ magnétique comporte un autre point de valeur de crête (Pm') situé du côté de la chambre de génération de plasma (35; 135) éloigné de la chambre de liaison (37; 137) et de la chambre de réaction (40; 140).

6. Appareil selon l'une quelconque des revendications 1 à 5, dans lequel la fréquence prédéterminée est approximativement égale à 2,45 GHz, et les intensités de champ magnétique au point de résonance cyclotron (Pc) et au point de valeur de crête (Pm) de la revendication 1 sont respectivement égale à 0,0875 T (875 Gauss) et comprise entre 0,15 et 0,25 T (1,5 KGauss et 2,5 KGauss).

7. Appareil selon l'une quelconque des revendications 1 à 6, dans lequel le rapport de miroir du miroir magnétique est compris entre 2 et 3.

8. Appareil selon l'une quelconque des revendications 1 à 7, dans lequel le moyen de génération de champ magnétique (36; 136, 136') comprend au moins un solénoïde (36; 136).

9. Appareil selon l'une quelconque des revendications 1 à 8, dans lequel les chambres (37, 35, 40; 137, 135, 140) sont constituées d'aluminium.

10. Appareil selon l'une quelconque des revendications 1 à 9, comprenant en outre un filtre de protection (38), positionné entre le point de valeur de crête (Pm) de la revendication 1 et la chambre de réaction (40; 140), servant à empêcher une fuite de puissance en hyperfréquence dans la chambre de réaction, le filtre étant pourvu de trous pour permettre le passage des radicaux et des ions.

FIG.1

FIG.3

## FIG. 2 (a)

## FIG. 2 (b)

*FIG. 4(a)*

*FIG. 4(b)*

microwave power

3